# EUROPEAN PATENT APPLICATION

(11) **EP 4 538 307 A1**
(43) Date of publication of application: **16.04.2025**
(21) Application number: 23866646.5
(22) Date of filing: 08.12.2023
(51) Int. Cl.: C08F 210/16, C08F 210/14, C08F 210/08, C09J 123/08, C09J 11/06, C09J 7/10, C09J 7/30, H01L 31/048

(54) **POLYOLEFIN ELASTOMER AND USE THEREOF IN PHOTOVOLTAIC ENCAPSULATION FILM**

(30) Priority: 28.08.2023 CN 202311082410
(71) Applicant: Wanhua Chemical Group Co., Ltd., Yantai, Shandong 264006 (CN)
(72) Inventor: HUANG, Lingyan, Yantai, Shandong 264006 (CN); WANG, Xinyu, Yantai, Shandong 264006 (CN); TIAN, Qin, Yantai, Shandong 264006 (CN); ZHANG, Jie, Yantai, Shandong 264006 (CN); WANG, Jinqiang, Yantai, Shandong 264006 (CN); LIN, Xiaojie, Yantai, Shandong 264006 (CN); ZHANG, Yanyu, Yantai, Shandong 264006 (CN); WANG, Lei, Yantai, Shandong 264006 (CN); HE, Yong, Yantai, Shandong 264006 (CN)
(74) Representative: HGF
(86) International application number: PCT/CN2023/137520
(87) International publication number: WO 2025/043950

(57) **Abstract**

Provided are a polyolefin elastomer for photovoltaic packaging films and a composition thereof, a preparation method therefor and an application thereof. The polyolefin elastomer is an atactic polymer or a block polymer composed of ethylene and α-olefin, and the polyolefin elastomer has a molecular mass M_{w} of 30000-200000, **PDI** of 1.5-3, MFR measured of 1-50 g/10 min at a temperature of 190 °C and a load of 2.16 kg, a density of 0.85-0.95 g/cm³, and a monomer insertion rate of 10-65wt%, and in the temperature rising elution process of TGIC-trichlorobenzene, the polyolefin resin has a soluble substances content of 0.1%-20% at a temperature of less than or equal to 40°C. Photovoltaic encapsulation films used a composition prepared by the elastomer have better optical performance, electrical insulation performance and anti-PID performance.

## Description

### TECHNICAL FIELD

The present disclosure relates to a polyolefin elastomer for photovoltaic packaging films, and belongs to the technical field of photovoltaic adhesive films.

### BACKGROUND

The solar power generation device is a device that converts light energy into electrical energy by a solar photovoltaic cell module under the action of P-N junction, wherein the most important core device is the solar photovoltaic cell module. The solar photovoltaic cell module is a sandwich device with a solar cell at the center and photovoltaic adhesive films on two sides of the battery, and two sides of the adhesive film are photovoltaic glass or backboard, which are prepared into photovoltaic modules through heating and laminating. Since the overall operating lifetime of the photovoltaic module is up to 25 years, the packaging adhesive film of the module is very important, and once the adhesive film is ineffective, the module will be scrapped and the operating lifetime will be reduced.

At present, crystalline silicon PERCs are still the mainstream photovoltaic cells on the market, but the long-term reliable and stable operation of the PERC modules is facing a serious challenge, i.e., the PID effect (potential-induced degradation). The PID effect can degrade the output power of the solar cell module by 20%, and in a severe case, by more than or equal to 50%.

The real cause of the PID effect is still inconclusive, but the anti-PID performance of the adhesive film is still the most concerned problem in this field. In this field, the common method to improve the anti-PID performance of the adhesive film is to add a metal-ion capturing agent into the photovoltaic adhesive film, or add an ion conductive agent into the adhesive film; in this method, better anti-PID performance can be obtained by adjusting a formula of the adhesive film, but the problem is not solved thoroughly.

### SUMMARY

In the present disclosure, a POE particle with a special microstructure is prepared, and by adjusting a content of microscopic-soluble substances of the particle, the optimization of the optical performance and electrical performance of the particle are realized, especially the optimization of PID performance, and the preparation of a photovoltaic composition with high light transmittance and high anti-PID performance is realized.

The present disclosure adopts the technical solutions below.

In a first aspect, the present disclosure provides a polyolefin elastomer for photovoltaic packaging films, and the polyolefin elastomer is an atactic polymer or a block polymer composed of ethylene and α-olefin. In the temperature rising elution process of TGIC-trichlorobenzene, at a temperature of less than or equal to 40°C, a content of soluble substances is 0.1%-20wt%, for example, 0.2wt%, 0.5wt%, 1wt%, 2wt%, 5wt%, 10wt%, 15wt%; furthermore, the content of soluble substances is 0.1%-15wt%.

Furthermore, for the polyolefin elastomer, a molecular mass M_{w} is 30000-200000 (for example, 40000, 50000, 80000, 100000, 150000); a PDI is 1.5-3 (for example, 1.8, 2.0, 2.2, 2.5, 2.8); a MFR measured under a condition of a temperature of 190°C and a load of 2.16 kg is 1-50 g/10 min (for example, 2 g/10 min, 4 g/10 min, 5 g/10 min, 8 g/10 min, 10 g/10 min, 15 g/10 min, 20 g/10 min, 25 g/10 min, 30 g/10 min, 40 g/10 min); a density is 0.85-0.95 g/cm³ (0.86 g/cm³, 0.88 g/cm³, 0.9 g/cm³, 0.92 g/cm³, 0.94 g/cm³), and further, the density is 0.85-0.90 g/cm³; and a monomer insertion rate is 10-65wt% (for example, 12wt%, 15wt%, 20wt%, 25wt%, 30wt%, 35wt%, 40wt%, 45wt%, 50wt%, 60wt%), and further, the monomer insertion rate is 20-65wt%.

Furthermore, the polyolefin elastomer has a volume resistance of 10¹³-10¹⁸ Ω·cm, for example, 2*10¹³ Q-cm, 5*10¹³ Q-cm, 10¹⁴ Q-cm, 5*10¹⁴ Q-cm, 10¹⁵ Ω·cm, 5*10¹⁵ Ω·cm , 10¹⁶ Q-cm, 5*10¹⁶ Ω·cm, 10¹⁷ Ω·cm, 5*10¹⁷ Ω·cm.

Furthermore, for the polyolefin elastomer, the α-olefin is an olefin having 3-13 carbon atoms, and preferably, the α-olefin is one or more of propylene, butene, hexene, octene, nonene, and decene.

Furthermore, for example, a structural formula of the polyolefin elastomer can be represented by: 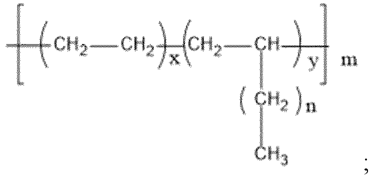
wherein, n is any integer ranging from 0 to 10, for example, 1, 2, 3, 4, 5, 6, 7, 8, 9; and
values of x, y, and m can be selected commonly in this field.

In a second aspect, the present disclosure provides a preparation method of the polyolefin elastomer mentioned above.

Furthermore, the preparation method of the polyolefin elastomer for photovoltaic packaging films comprises the following steps:
by using cationic coordination polymerization, mixing a solvent with α-olefin in a certain proportion, then injecting the same into a reaction kettle, and introducing ethylene gas with a pressure of 1-5 MPa (for example, 2 MPa, 3 MPa, 4 MPa) at a temperature of 120-160 °C (for example, 130 °C, 140 °C, 150 °C), and adding a main catalyst and a cocatalyst into the reaction kettle, stirring and reacting for 3-15 min (for example, 4 min, 5 min, 8 min, 10 min, 12 min) to obtain a reactant solution; and
adding an inactivator into the system, performing a full reaction to obtain a product, cooling and drying the product to obtain a polymer.

In the preparation method, the solvent is selected from an aliphatic hydrocarbon solvent and/or an aromatic hydrocarbon solvent; preferably, the aliphatic hydrocarbon solvent is selected from one or more of n-butane, iso-butane, n-pentane, cyclopentane, methyl cyclopentane, methylene cyclopentane, n-hexane, cyclohexane, methyl cyclohexane, ethyl cyclohexane, n-heptane, n-octane, n-nonane, or Isopar E; preferably, the aromatic hydrocarbon solvent is selected from one or more of benzene, toluene, xylene, monochlorobenzene, dichlorobenzene, or dichlorotoluene.

The α-olefin is an olefin having 3-13 carbon atoms, and preferably, the α-olefin is one or more of propylene, butene, hexene, octene, nonene, and decene.

The main catalyst is a metallocene catalyst and/or a post-metallocene catalyst, and preferably, the main catalyst is one or more of dimethylsilyl(N-tert-butylamino)(tetramethyl cyclopentadienyl) titanium dichloride, dimethylsilyl(N-tert-butylamino)(tetramethyl cyclopentadienyl) dimethyl titanium, dimethylsilyl(N-tert-butylamino)(fluorenyl) titanium dichloride, (pentamethyl cyclopentadienyl) trimethoxy titanium, diphenylmethylene (cyclopentadiene) (9-fluorenyl) zirconium dichloride, dimethyl dimethylsilyl bis(2-methyl-4-phenyl-1-indenyl) zirconium dichloride), meso-dimethylsilyl bis(1-indenyl) zirconium dichloride, (bis(methylcyclopentadiene) zirconium dichloride), (bis(1,3-dimethyl cyclopentadienyl)zirconium dichloride, (cyclopentadienyl)(1,2-dimethoxyethane)zirconium trichloride, diphenyl silyl(cyclopentadiene)(9-fluorenyl)zirconium dichloride, rac-dimethylsilyl bis(2-methyl-1-indenyl)zirconium dichloride, diphenylmethylene cyclopentadiene (2,7-di-tert-butyl-fluorenyl)zirconium dichloride, di-p-tolyl methylene cyclopentadiene (2,7-di-tert-butyl-fluorenyl) zirconium dichloride, dimethyl bis(propylcyclopentadienyl)hafnium, bis(n-butyl cyclopentadiene) hafnium dichloride, and dimethylsilyl bis(2-methyl-4-phenylindenyl)zirconium dichloride; the additive amount of the main catalyst can be confirmed by those skilled in the field according to the activity of the catalyst and the weight of the target product, and generally, the additive amount of the main catalyst can be 1-10 ppm by the weight of the polymer (for example, 2 ppm, 4 ppm, 5 ppm, 8 ppm).

The cocatalyst is at least one of alkyl aluminum, organoboron compound, alkyl aluminoxane, and preferably, the cocatalyst is one or more of methyl aluminoxane, modified methyl aluminoxane, ethyl aluminoxane, trimethyl aluminum, triethyl aluminum, triisobutyl aluminum, and tris(pentafluorophenyl)boron; an additive amount of the cocatalyst is 200-9800 ppm by the weight of the polymer (for example, 250 ppm, 500 ppm, 1000 ppm, 2000 ppm, 5000 ppm, 8000 ppm, 9000 ppm).

The inactivator is a mixture of inactivator A and inactivator B, and the inactivator A and the inactivator B have a mixing mass ratio of 1-5:1-5 (for example, 1:1, 1:2, 1:3, 1:4, 1:5, 2:1, 2:3, 2:5, 3:1, 3:2, 3:4, 3:5, 4:1, 4:3, 4:5, 5:1, 5:2, 5:3, 5:4), wherein the inactivator A is water and/or an alcohol having 2-20 carbon atoms, and the alcohol is preferably ethanol, ethylene glycol, n-propanol, glycerol, n-butanol, 2-butanol, neopentyl alcohol, 1,6-hexanediol, n-octanol, 2-ethyl hexanol, benzyl alcohol, n-decyl alcohol, dodecyl alcohol, myristyl alcohol, and hexadecyl alcohol; and the inactivator B is a ketone, and preferably, the ketone is one or more of dimethyl ketone, diethyl ketone, butanone, methyl isobutanone, valerophenone, ethyl octanone, methyl n-nonanone, methyl phenylhexanone, dipyrrolidone, dicyclo[3.3.1]non-3,7-dione, dimethyl cyclohexanedione, 2,2,6-trimethyl-1,4-cyclohexanedione, diphenylethanedione, 3-methyl-2,4-nonanedione, 1-phenyl-2,4-pentanedione, and 2,4-decanedione. A usage amount of the inactivator is 600-150000 ppm by the weight of the polymer (for example, 800 ppm, 1000 ppm, 2000 ppm, 5000 ppm, 10000 ppm, 50000 ppm, 100000 ppm, 120000 ppm).

In another aspect, the present disclosure provides an application of the polyolefin elastomer in the preparation of a photovoltaic packaging film.

Furthermore, the photovoltaic packaging film comprises the polyolefin elastomer, a cross-linking agent, an auxiliary cross-linking agent, a coupling agent, and an antioxidant.

In a specific solution, a usage amount of each component is:
the polyolefin elastomer: 100 parts by weight;
the cross-linking agent: 0.1-5 parts by weight (for example, 0.2 parts by weight, 0.4 parts by weight, 1 part by weight, 1.5 parts by weight, 2.5 parts by weight, 4 parts by weight, 4.5 parts by weight), preferably, 0.5-2 parts by weight;
the auxiliary cross-linking agent: 0.1-5 parts by weight (for example, 0.2 parts by weight, 0.4 parts by weight, 1 part by weight, 1.5 parts by weight, 2.5 parts by weight, 4 parts by weight, 4.5 parts by weight), preferably, 0.1-2 parts by weight;
the coupling agent: 0.1-3 parts by weight (for example, 0.2 parts by weight, 0.4 parts by weight, 0.5 parts by weight, 1 part by weight, 1.5 parts by weight, 2 parts by weight, 2.5 parts by weight), preferably, 0.1-0.6 parts by weight; and
the antioxidant: 0.01-1 parts by weight (for example, 0.02 parts by weight, 0.04 parts by weight, 0.06 parts by weight, 0.1 parts by weight, 0.2 parts by weight, 0.4 parts by weight, 0.8 parts by weight), preferably, 0.05 to 0.5 parts by weight.

Furthermore, the cross-linking agent is a peroxide cross-linking agent, which comprises, but not limited to, one or more of the following: tert-butyl peroxy isopropyl carbonate, 2,5-dimethyl-2,5-(bis-tert-butylperoxy)hexane, tert-butyl peroxy carbonic acid-2-ethylhexyl ester, 1,1-bis(tert-butylperoxy)-3,3,5-trimethylcyclohexane, 1,1-bis(tert-pentylperoxy)-3,3,5-trimethylcyclohexane, 1,1-bis(tert-pentylperoxy)-3,3,5-trimethylcyclohexane, 1,1-bis(tert-pentyl peroxy)cyclohexane, 1,1-bis(tert-butylperoxy)cyclohexane, 2,2-bis(tert-butylperoxy)butane, tert-butyl peroxy 2-ethylhexyl carbonate, tert-pentyl peroxy (2-ethylhexyl)carbonate, and tert-butyl peroxy 3,3,5-trimethyl hexanoate.

Furthermore, the auxiliary cross-linking agent is one or more of polyfunctional acrylate substances, which comprise, but not limited to: trimethylolpropane triacrylate, trimethylolpropane trimethylacrylate, pentaerythritol triacrylate, triallyl isocyanurate, ethoxylated trimethylolpropane triacrylate, propoxylated trimethylolpropane triacrylate, ethoxylated glyceryl triacrylate, propoxylated glyceryl triacrylate, pentaerythritol tetraacrylate, ethoxylated pentaerythritol tetraacrylate, trimethylolpropane tetraacrylate, bis-trimethylolpropane tetraacrylate, bis-trimethylolpropane tetramethacrylate, propoxylated pentaerythritol tetraacrylate, tricyclodecane dimethanol diacrylate, propoxylated neopentyl glycol diacrylate, ethoxylated bisphenol A diacrylate, ethoxylated bisphenol A dimethacrylate, 2-butyl-2-ethyl-1,3-propylene glycol diacrylate, diethylene glycol dimethacrylate, triethylene glycol dimethacrylate, and polyethylene glycol dimethacrylate.

Furthermore, the coupling agent is a silane-coupling agent, which comprises, but not limited to, one or more of the following: γ-chloropropyl methoxysilane, dimethylvinyl ethoxysilane, vinyl tris(β-methoxyethoxy)silane, γ-methacryloxypropyl trimethoxysilane, vinyl triacetoxysilane, γ-glycidyl ether oxypropyl trimethoxysilane, 3-(trimethoxysilyl)propyl-2-methyl-2-acr^{y}late, anilino methyl triethoxysilane, octyl trimethoxysilane.

Furthermore, the antioxidant is one or more of hindered phenol antioxidants or phosphate ester antioxidants, which comprise, but not limited to: β-[3,5-di-tert-butyl-4-hydroxyphenyl] propionic acid n-octadecyl alcohol ester, tetra[β-(3,5-di-tert-butyl-4-hydroxyphenyl) propionic acid]pentaerythritol ester, 1,2-bis[β-(3,5-di-tert-butyl-4-hydroxyphenyl)propionyl]hydrazine, 2,2'-oxamido-bis[ethyl-3-(3,5-di-tert-butyl-4-hydroxyphenyl)]propionate, N,N'-hexamethylene bis(3,5-di-tert-butyl-4-hydroxyphenylpropanamide), 1,3,5-tris(3,5-di-tert-butyl-4-hydroxyl benzyl)-1,3,5-triazine-2,4,6(1H,3H,5H)triketone, triethylene glycol bis[3-(3-tert-buty-5-methyl-4-hydroxyphenyl)propionate], 4,6-bis(octylthiomethyl)o-cresol, tris[2,4-di-tert-butylphenyl] phosphite, bis[2,4-di-tert-butylphenyl]pentaerythritol diphosphite, and bis(2,6-di-tert-butyl-4-methylphenyl)pentaerythritol diphosphate.

Furthermore, the preparation of the photovoltaic packaging film can adopt, a conventional method in the field, comprising the following steps, for example, high-temperature premixing of raw materials, melt extrusion, film casting, cooling slitting, and winding.

The present disclosure has the following beneficial effects.

In the present disclosure, the soluble substances with a low content (a content of less than 20%) can be obtained at a temperature of less than or equal to 40°C, ensuring a low proportion of small molecular weight portion of the matrix resin; in one aspect, the POE particles with high anti-PID can be obtained without upgrading the formula of the adhesive film, and the anti-PID performance of the photovoltaic adhesive film can be radically improved; and in another aspect, the resin has higher optical performance and electrical insulation performance.

### DETAILED DESCRIPTION

The present disclosure is described in detail below by using examples, and the examples in the present disclosure are merely used as a description of the present disclosure and do not limit the scope of the present disclosure.

In the present disclosure, "part" and "%" are measured by weight, unless otherwise specified.

Main Materials:
ethylene-octene copolymer A (with MFR of 2 g/10min (190 °C, 2.16 kg), M_{w} of 57000, PDI of 2.8, a density of 0.87 g/cm³, an octene content of 40wt%, and a soluble substances content of 1wt% at a temperature of less than or equal to 40 °C, self-made);
ethylene-octene copolymer B (with MFR of 5 g/10min (190 °C, 2.16 kg), M_{w} of 70000, PDI of 2.3, a density of 0.868 g/cm³, a soluble substances content of 3wt% at a temperature of less than or equal to 40 °C, and an octene content of 33wt%, self-made);
ethylene-butene copolymer C (with MFR of 5 g/10min (190 °C, 2.16 kg), M_{w} of 75000, PDI of 2.2, a density of 0.877 g/cm³, a soluble substances content of 5wt% at a temperature of less than or equal to 40 °C, and a butene content of 24wt%, self-made);
ethylene-hexene copolymer D (with MFR of 25 g/10min (190 °C, 2.16 kg), M_{w} of 40000, PDI of 2, a density of 0.875 g/cm³, a hexene content of 30wt%, and a soluble substances content of 7wt% at a temperature of less than or equal to 40 °C, self-made);
ethylene-octene copolymer E (with MFR of 35 g/10min (190 °C, 2.16 kg), M_{w} of 100000, PDI of 2.5, a density of 0.873 g/cm³, an octene content of 30wt%, and a soluble substances content of 15wt% at a temperature of less than or equal to 40 °C, self-made);
ethylene-hexene copolymer F (with MFR of 3 g/10min (190 °C, 2.16 kg), M_{w} of 13000, PDI of 2.1, a density of 0.872 g/cm³, an hexene content of 35wt%, and a soluble substances content of 38wt% at a temperature of less than or equal to 40 °C, self-made);
methyl aluminoxane, from Akzo, 10% in toluene;
modified methyl aluminoxane, from Nouryon;
dimethylsilyl bis(2-methyl-4-phenyl indenyl)zirconium dichloride, from Honor Shine Chemical Co., Ltd.;
   di-p-tolyl methylene cyclopentadiene (2,7-di-tert-butyl-fluorenyl) zirconium dichloride, from Infinity Scientific; dimethylsilyl(N-tert-butylamino)(tetramethyl cyclopentadienyl) dimethyl titanium, from Sinocompound Catalysts Co., Ltd.; dimethyl bis(propyl cyclopentadienyl)hafnium, from Infinity Scientific; diphenylmethylene cyclopentadiene (2,7-di-tert-butyl-fluorenyl)zirconium dichloride, from Honor Shine Chemical Co., Ltd.; and
   dimethylsilyl(tert-butylamino)tetramethyl cyclopentadienyl dimethyl titanium, from Sinocompound.

### Test Instruments

Melt index tester: ZwickMflow, with a test standard of ASTM D1238.

Extruder: a single-screw extruder (L/D = 35) with a screw diameter of 30 mm.

Molecular mass and insertion rate tester: Polymer Char, GPC-IR.

Soluble substances analysis: Polymer Char, TGIC, with trichlorobenzene as a solvent. The separation and characterization of different components of polyolefin are achieved by temperature-rising elution with TGIC. A sample is dissolved in trichlorobenzene at 165 °C and passed through a TGIC chromatographic column, program cooling to 40 °C (20 °C/min), a partial polyolefin structure is attached to the column due to the adsorption with a graphite column and crystallization, and rinsed with a flow rate of 0.5 mL/min, and a soluble matter is washed to a detector IR5 for detection, subjected to temperature rising elution, and heated to 165 °C with a rate of 2 °C/min, and the molecules attached to the column are sequentially washed out according to their crystallization capacity and the amount of short branched chains.

PID equipment: Shanghai Zealwe Environmental Chamber, Model EW-EC03PID02-021220.

Power test equipment: Nanjing Lichttechnik, Model LXT-CELL.

Resistance Meter: Keithley, Model 6517B, 1000 v, 10 min.

### Preparation Example

Preparation of ethylene-octene copolymer A: by cationic metallocene coordination polymerization, 200 g of octene was added into 1 L of n-butane solvent to prepare a solution, and the solution was added into a reaction kettle, the temperature was raised to 150 °C, ethylene gas was introduced, and a pressure in the kettle was controlled to be 2.5 MPa. 1 mg of the dimethylsilyl bis(2-methyl-4-phenyl indenyl)zirconium dichloride as a main catalyst and 5 mL of a toluene solution containing 10wt% of methyl aluminoxane as a cocatalyst were added to the reaction kettle, stirred and reacted for 15 min to obtain a reactant solution; and
water was mixed with 3-methyl-2,4-nonanedione at a mass ratio of 3:1, and a mixed solution with a total mass of 1.2 g was fully reacted with the reactant solution, and a obtained product was cooled, filtered, and dried to obtain the ethylene-octene copolymer A with MFR of 2 g/10 min (190 °C, 2.16 kg), M_{w} of 57000, PDI of 2.8, a density of 0.87 g/cm³, an octene content of 40wt%, a soluble substances content of 1wt% at a temperature of less than or equal to 40 °C, and a volume resistance of 10¹⁷Ω·cm.

Preparation of ethylene-octene copolymer B: by cationic metallocene coordination polymerization, 190 g of octene was added to 1 L of Isopar E to prepare a solution, and then the solution was added into a reaction kettle, the temperature was raised to 150 °C, ethylene gas was introduced, and a pressure in the kettle was controlled to be 2.5 MPa. 0.87 mg of di-p-tolyl methylene cyclopentadiene (2,7-di-tert-butyl-fluorenyl) zirconium dichloride as a main catalyst and 7mL of a toluene solution containing 10wt% of methyl aluminoxane as a cocatalyst were added to the reaction kettle, stirred and reacted for 15 min to obtain a reactant solution; and
water was mixed with 3-methyl-2,4-nonanedione at a mass ratio of 4:1, and the mixed solution with a total mass of 900 mg was mixed with the reactant solution for a full reaction, and a obtained product was cooled, and a solid precipitate was obtained, filtered, and dried to obtain the ethylene-octene copolymer B with MFR of 5 g/10 min (190 °C, 2.16 kg), M_{w} of 70000, PDI of 2.3, a density of 0.868 g/cm³, a soluble substances content of 3wt% at a temperature of less than or equal to 40 °C, an octene content of 33wt%, and a volume resistance of 10¹⁷ Ω·cm.

Preparation of ethylene-butylene copolymer C: by cationic metallocene coordination polymerization, 1 L of Isopar E was added into a reaction kettle, and heated to 140 °C, and according to an ethylene-to-butene ratio of 1:1, the gas was introduced, and a pressure in the kettle was controlled to be 3 MPa. 0.8 mg of dimethylsilyl (N-tert-butylamino) (tetramethyl cyclopentadienyl) dimethyl titanium as a main catalyst and 8 mL of a Isopar E solution containing 7%Al of modified methyl aluminoxane as a cocatalyst were added into the reaction kettle, stirred and reacted for 15 min to obtain a reactant solution; and
water was mixed with dipyrrolidone at a mass ratio of 1:2, and the mixed solution with a total mass of 600 mg was fully reacted with the reactant solution, and a obtained product was cooled, filtered, and dried to obtain the ethylene-butylene copolymer C with MFR of 5 g/10 min (190 °C, 2.16 kg), M_{w} of 75000, PDI of 2.2, a density of 0.877 g/cm³, a soluble substances content of 5wt% at a temperature of less than or equal to 40 °C, an octene content of 24wt%, and a volume resistance of 10¹⁶ Q. cm.

Preparation of ethylene-hexene copolymer D: by cationic metallocene coordination polymerization, 200 g of hexene was added into 1 L of Isopar E to prepare a solution, and then the solution was added into a reaction kettle, the temperature was raised to 140 °C, ethylene gas was introduced, and a pressure in the kettle was controlled to be 2.8 MPa. 0.9 mg of dimethyl bis(propyl cyclopentadienyl) hafnium as a main catalyst and 3 mL of a toluene solution containing 10wt% of methyl aluminoxane as a cocatalyst were added to the reaction kettle, stirred and reacted for 15 min to obtain a reactant solution; and
n-butanol was mixed with 1-phenyl-2,4-pentanedione at a mass ratio of 2:3, and the mixed solution with a total mass of 400 mg was fully reacted with the reactant solution, and a obtained product was cooled, filtered, and dried to obtain the ethylene-hexene copolymer D with MFR of 25 g/10 min (190 °C, 2.16 kg), M_{w} of 40000, PDI of 2, a density of 0.875 g/cm³, an hexene content of 30wt%, a soluble substances content of 7wt% at a temperature of less than or equal to 40 °C, and a volume resistance of 10¹⁵ Ω·cm.

Preparation of ethylene-octene copolymer E: by cationic metallocene coordination polymerization, 190 g of octene was added into 1 L of Isopar E to prepare a solution, and then the solution was added into a reaction kettle, the temperature was raised to 150 °C, ethylene gas was introduced, and a pressure in the kettle was controlled to be 3.5 MPa. 1 mg of diphenylmethylene cyclopentadiene (2,7-di-tert-butyl-fluorenyl) zirconium dichloride as a main catalyst and 10 mL of an Isopar E solution containing 7%Al of modified methyl aluminoxane as a cocatalyst were added into the reaction kettle, stirred and reacted for 15 min to obtain a reactant solution; and
ethanol was mixed with ethyl octanone at a mass ratio of 3:5, and the mixed solution with a total mass of 200 mg was fully reacted with the reactant solution, and a obtained product was cooled, filtered, and dried to obtain the ethylene-octene copolymer E with MFR of 35 g/10 min (190 °C, 2.16 kg), M_{w} of 100000, PDI of 2.5, a density of 0.873 g/cm³, an octene content of 30wt%, a soluble substances content of 15% at a temperature of less than or equal to 40 °C, and a volume resistance of 10¹⁵ Ω·cm.

Preparation of ethylene-hexene copolymer F: by cationic metallocene coordination polymerization, 160 g of octene was added into 1 L of n-butane solvent to prepare a solution, and then the solution was added into a reaction kettle, the temperature was raised to 135 °C, ethylene gas was introduced, and a pressure in the kettle was controlled to be 2.5 MPa. 1 mg of dimethyl silicane (tert-butylamino)tetramethyl cyclopentadienyl dimethyl titanium as a main catalyst and 4 mL of a toluene solution containing 10wt% of methyl aluminoxane as a cocatalyst were added to the reaction kettle, stirred and reacted for 15 min to obtain a reactant solution; and
100 mg of water was fully reacted with the reactant solution, and then the obtained product was cooled, filtered, and dried to obtain the ethylene-hexene copolymer F with MFR of 3 g/10 min (190 °C, 2.16 kg), M_{w} of 13000, PDI of 2.1, a density of 0.872 g/cm³, a hexene content of 35wt%, a soluble substances content of 38% at a temperature of less than or equal to 40 °C, and a volume resistance of 10¹⁴ Ω·cm.

### Examples and Comparative Examples

### Example 1

9 g of tert-butyl peroxy 2-ethylhexyl carbonate, 5 g of triallyl isocyanurate, 2 g of γ-methacryloxy propyl trimethoxysilane, 1 g of γ-(2,3-epoxy propoxy)propyl trimethoxysilane, 1 g of bis[2,4-di-tert-butylphenyl] pentaerythritol diphosphite, and 1 g of β-[3,5-di-tert-butyl-4-hydroxyphenyl] propanoic acid n-octadecyl alcohol ester were added into 1000 g of the ethylene-octene copolymer A. The above raw materials were heated to 50 °C and mixed evenly, parameters of an extruder were adjusted, wherein temperatures from a discharge port to a die head were 80 °C, 90 °C, 90 °C, 90 °C, 90 °C, 95 °C, 95 °C, and 95 °C, a screw speed was 45 rpm, a traction speed was 0.7 rpm, and a winding speed was 1.3 rpm. The processes of extrusion, film casting, cooling-slitting, and winding were performed to obtain a packaging adhesive film for photovoltaic modules with a film thickness of 0.6 mm.

### Example 2

6 g of 1,1-bis(tert-butyl peroxy)-3,3,5-trimethyl cyclohexane, 2 g of tert-pentyl peroxy (2-ethylhexyl) carbonate, 4 g of trimethylolpropane triacrylate, 2 g of γ-methacryloxy propyl trimethoxysilane, 1g of γ-(2,3-epoxy propoxy)propyl trimethoxysilane, 0.1 g of antioxidant 1076, and 1 g of antioxidant 1010 were added into 1000 g of the ethylene-octene copolymer B. The above raw materials were heated to 50 °C and mixed evenly, parameters of an extruder were adjusted, wherein temperatures from a bottom feed port to a die head were 80 °C, 90 °C, 90 °C, 90 °C, 90 °C, 95 °C, 95 °C, and 95 °C, a screw speed was 45 rpm, a traction speed was 0.7 rpm, and a winding speed was 1.3 rpm. The processes of extrusion, film casting, cooling-slitting, and winding were performed to obtain a packaging adhesive film for photovoltaic modules with a film thickness of 0.6 mm.

### Example 3

20 g of tert-butyl peroxy 2-ethylhexyl carbonate, 7 g of triallyl isocyanurate, 8 g of dimethylvinyl ethoxysilane, and 0.5 g of tetra[β-(3,5-di-tert-butyl-4-hydroxyphenyl) propionic acid] pentaerythritol ester were added into 1000 g of the ethylene-butene copolymer C. The above raw materials were heated to 50 °C and mixed evenly, parameters of an extruder were adjusted, wherein temperatures from a bottom feed port to a die head were 80 °C, 90 °C, 90 °C, 90 °C, 90 °C, 95 °C, 95 °C, and 95 °C, a screw speed was 45 rpm, a traction speed was 0.7 rpm, and a winding speed was 1.3 rpm. The processes of extrusion, film casting, cooling-slitting, and winding were performed to obtain a packaging adhesive film for photovoltaic modules with a film thickness of 0.6 mm.

### Example 4

15 g of 2,2-bis(tert-butyl peroxy) butane, 10 g of triallyl isocyanurate, 15 g of γ-methacryloxy propyl trimethoxysilane, 0.1 g of 1,2-bis[β-(3,5-di-tert-butyl-4-hydroxyphenyl)propionyl] hydrazine, and 1 g of triethylene glycol bis[3-(3-tert-butyl-5-methyl-4-hydroxyphenyl) propionate] were added into 1000 g of the ethylene-hexene copolymer D. The above raw materials were heated to 50 °C and mixed evenly, parameters of an extruder were adjusted, wherein temperatures from a bottom feed port to a die head were 80 °C, 90 °C, 90 °C, 90 °C, 90 °C, 95 °C, 95 °C, and 95 °C, a screw speed was 45 rpm, a traction speed was 0.7 rpm, and a winding speed was 1.3 rpm. The processes of extrusion, film casting, cooling-slitting, and winding were performed to obtain a packaging adhesive film for photovoltaic modules with a film thickness of 0.6 mm.

### Example 5

10 g of tert-butyl peroxy 2-ethylhexyl carbonate, 8 g of triallyl isocyanurate, 2 g of octyl trimethoxysilane, 1 g of γ-(2,3-epoxy propoxy)propyl trimethoxysilane, 0.1 g of triethylene glycol bis[3-(3-tert-butyl-5-methyl-4-hydroxyphenyl) propionate], and 1 g of bis[2,4-di-tert-butylphenyl] pentaerythritol diphosphite were added into 1000 g of the ethylene-octene copolymer E. The above raw materials were heated to 50 °C and mixed evenly, parameters of an extruder were adjusted, wherein temperatures from a bottom feed port to a die head were 80 °C, 90 °C, 90 °C, 90 °C, 90 °C, 95 °C, 95 °C, and 95 °C, a screw speed was 45 rpm, a traction speed was 0.7 rpm, and a winding speed was 1.3 rpm. The processes of extrusion, film casting, cooling and slitting, and winding were performed to obtain a packaging adhesive film for photovoltaic modules with a film thickness of 0.6 mm.

### Comparative Example 1

9 g of tert-butyl peroxy 2-ethylhexyl carbonate, 5 g of triallyl isocyanurate, 2 g of γ-methacryloxy propyl trimethoxysilane, 1 g of γ-(2,3-epoxy propoxy)propyl trimethoxysilane,1 g of bis[2,4-di-tert-butylphenyl] pentaerythritol diphosphate, and 1 g of β-[3,5-di-tert-butyl-4-hydroxyphenyl] propanoic acid n-octadecyl alcohol ester were added into 1000 g of the ethylene-hhexene copolymer F. The above raw materials were heated to 50 °C and mixed evenly, parameters of an extruder were adjusted, wherein temperatures from a bottom feed port to a die head were 80 °C, 90 °C, 90 °C, 90 °C, 90 °C, 95 °C, 95 °C, and 95 °C, a screw speed was 45 rpm, a traction speed was 0.7 rpm, and a winding speed was 1.3 rpm. The processes of extrusion, film casting, cooling-slitting, and winding were performed to obtain a packaging adhesive film for photovoltaic modules with a film thickness of 0.6 mm.

The packaging adhesive films prepared in the above examples and comparative examples were used for preparing photovoltaic modules. Their light transmittance and PID performance were tested, and the test results are shown in the table below.

The test method is as follows.

PID attenuation: the adhesive films prepared in each example and comparative example were all used as a front packaging adhesive film and a back packaging adhesive film of the same photovoltaic module, and the photovoltaic module was composed of a tempered glass, an upper packaging adhesive film, bifacial crystalline silicon cell sheet, a lower packaging adhesive film, and a tempered glass. By a laminator, at 150 °C, vacuum was first performed and then pressurization was performed, and cross-linking was performed for 18 min. The module was subjected to HAST (85°C, 85%RH, -1500 V, 192 h) to test a power change before and after aging.

Light transmittance test: According to a spectrophotometer method of GB/T 2410-2008, average values of the light transmittance of the wavelength range of 290-380 nm and 380-1100 nm were calculated, respectively.

### Test Results of Examples and Comparative Example

| Performance | Example 1 | Example 2 | Example 3 | Example 4 | Example 5 | Comparative Example 1 |
|---|---|---|---|---|---|---|
| PID attenuation of front after 96 h /% | 2.1 | 2.3 | 2.5 | 3 | 3.5 | 6 |
| PID attenuation of back after 96 h /% | 3.7 | 4.2 | 4.9 | 4.6 | 5 | 7.9 |
| Light transmittance of 290-380 nm /% | 84.8 | 83.4 | 82.5 | 82.5 | 81.9 | 81.5 |
| Light transmittance of 380-1100 nm /% | 92 | 91.7 | 91.6 | 91.7 | 91.3 | 90.9 |

From the comparison of the performance test data in the above table of Examples and Comparative Example, it can be seen that:
the present disclosure provides a polyolefin elastomer for photovoltaic packaging adhesive films and a composition thereof, the soluble substances content is controlled in the synthesis process of the matrix resin, so that the anti-PID performance of the matrix resin itself is improved, and the prepared photovoltaic adhesive film can have high anti-PID performance without adding anti-PID additives at the formula level, which can be widely popularized to the field of adhesive films, reduces the addition of additives, and its optical performance is also very good.

The above are only preferred embodiments of the present disclosure, and it should be noted that for a person skilled in the art, a number of improvements and additions can be made without departing from the solutions of the present disclosure, and these improvements and additions shall also be regarded as the protection scope of the present disclosure.

## Claims

1. A polyolefin elastomer, which is an atactic polymer or a block polymer composed of ethylene and α-olefin; wherein the α-olefin of the polyolefin elastomer is an olefin having 3-13 carbon atoms;
in the temperature rising elution process of TGIC-trichlorobenzene, the polyolefin elastomer has a content of soluble substances of 0.1%-15wt% at a temperature of less than or equal to 40°C; and
the polyolefin elastomer has a molecular mass M_{w} of 30000-200000, PDI of 1.5-3, MFR of 1-50 g/10 min measured at a temperature of 190 °C and a load of 2.16 kg, a density of 0.85-0.90 g/cm³, and a monomer insertion rate of 20-65wt%.

2. The polyolefin elastomer according to claim 1, wherein the polyolefin elastomer has a volume resistance of 10¹³-10¹⁸ Ω·cm.

3. The polyolefin elastomer according to claim 1 or 2, wherein the α-olefin is selected from one or more of propylene, butene, hexene, octene, nonene, and decene.

4. A preparation method of the polyolefin elastomer according to any one of claims 1-3, comprising the following steps:
mixing a solvent with α-olefin, then injecting the same into a reaction kettle, and introducing ethylene gas at a certain temperature, and adding a main catalyst and a cocatalyst into the reaction kettle and stirring for reaction to obtain a reactant solution; and
adding an inactivator into the system, and performing a full reaction to obtain a product;
the inactivator is a mixture of inactivator A and inactivator B, and the inactivator A and the inactivator B have a mixing ratio of 1-5:1-5;
wherein the inactivator A is water and/or an alcohol having 2-20 carbon atoms; and the inactivator B is a ketone.

5. The preparation method according to claim 4, wherein the main catalyst is selected from a metallocene catalyst and/or a post-metallocene catalyst.

6. The preparation method according to claim 5, wherein the main catalyst is selected form one or more of dimethylsilyl(N-tert-butylamino)(tetramethyl cyclopentadienyl) titanium dichloride, dimethylsilyl(N-tert-butylamino)(tetramethyl cyclopentadienyl) dimethyl titanium, dimethylsilyl(N-tert-butylamino)(fluorenyl) titanium dichloride, (pentamethyl cyclopentadienyl) trimethoxy titanium, diphenylmethylene (cyclopentadiene) (9-fluorenyl) zirconium dichloride, meso-dimethyl silyl bis(1-indenyl) zirconium dichloride, bis(methylcyclopentadiene) zirconium dichloride, bis(1,3-dimethyl cyclopentadienyl)zirconium dichloride, (cyclopentadienyl) (1,2-dimethoxyethane)zirconium trichloride, diphenyl silyl(cyclopentadiene)(9-fluorenyl) zirconium dichloride, rac-dimethylsilyl bis(2-methyl-1-indenyl)zirconium dichloride, diphenylmethylene cyclopentadiene (2,7-di-tert-butyl-fluorenyl)zirconium dichloride, di-p-tolyl methylene cyclopentadiene (2,7-di-tert-butyl-fluorenyl) zirconium dichloride, dimethyl bis(propylcyclopentadienyl)hafnium, bis(n-butyl cyclopentadiene) hafnium dichloride, and dimethylsilyl bis(2-methyl-4-phenylindenyl)zirconium dichloride

7. The preparation method according to any one of claims 4-6, wherein the cocatalyst is at least one of alkyl aluminum, an organoboron compound, or alkyl aluminoxane.

8. The preparation method according to claim 7, wherein the cocatalyst is selected from one or more of methyl aluminoxane, modified methyl aluminoxane, ethyl aluminoxane, trimethyl aluminum, triethyl aluminum, triisobutyl aluminum, and tri(pentafluorophenyl) boron.

9. The preparation method according to any one of claims 4-8, wherein the inactivator A is selected from one or more of ethanol, ethylene glycol, n-propanol, glycerol, n-butanol, 2-butanol, neopentyl alcohol, 1,6-hexanediol, n-octanol, 2-ethyl hexanol, benzyl alcohol, n-decyl alcohol, dodecyl alcohol, myristyl alcohol, and hexadecyl alcohol; and
the inactivator B is selected from one or more of dimethyl ketone, diethyl ketone, butanone, methyl isobutanone, valerophenone, ethyl octanone, methyl n-nonanone, methyl phenylhexanone, dipyrrolidone, dicyclo[3.3.1]non-3,7-dione, dimethyl cyclohexanedione, 2,2,6-trimethyl-1,4-cyclohexanedione, diphenylethanedione, 3-methyl-2,4-nonanedione, 1-phenyl-2,4-pentanedione, and 2,4-decanedione.

10. An application of the polyolefin elastomer according to any one of claims 1-3 or a polyolefin elastomer prepared by the preparation method according to any one of claims 4-9 in the preparation of photovoltaic packaging films.

11. A photovoltaic packaging film, comprising: the polyolefin elastomer according to any one of claims 1-3 or a polyolefin elastomer prepared by the preparation method according to any one of claims 4-9, a cross-linking agent, an auxiliary cross-linking agent, a coupling agent, and an antioxidant.

12. The photovoltaic packaging film according to claim 11, wherein a usage amount of each component of the photovoltaic packaging film is:
the polyolefin elastomer: 100 parts by weight,
the cross-linking agent: 0.1-5 parts by weight,
the auxiliary cross-linking agent: 0.1-5 parts by weight,
the coupling agent: 0.1-3 parts by weight, and
the antioxidant: 0.01-1 parts by weight.

13. The photovoltaic packaging film according to claim 11 or 12, wherein the cross-linking agent is a peroxide cross-linking agent; and/or
the auxiliary cross-linking agent is one or more of polyfunctional acrylate substances; and/or
the coupling agent is a silane-coupling agent; and/or
the antioxidant is one or more of hindered phenol antioxidants or phosphate ester antioxidants.

14. The photovoltaic packaging film according to claim 13, wherein the cross-linking agent is selected from one or more of the following: tert-butyl peroxy isopropyl carbonate, 2,5-dimethyl-2,5-(bis-tert-butylperoxy)hexane, tert-butyl peroxy carbonic acid-2-ethylhexyl ester, 1,1-bis(tert-butylperoxy)-3,3,5-trimethylcyclohexane, 1,1-bis(tert-pentylperoxy)-3,3,5-trimethylcyclohexane, 1,1-bis(tert-pentylperoxy)-3,3,5-trimethylcyclohexane, 1,1-bis(tert-pentyl peroxy)cyclohexane, 1,1-bis(tert-butylperoxy)cyclohexane, 2,2-bis(tert-butylperoxy)butane, tert-butyl peroxy 2-ethylhexyl carbonate, tert-pentyl peroxy (2-ethylhexyl)carbonate, and tert-butyl peroxy 3,3,5-trimethyl hexanoate; and/or
the auxiliary cross-linking agent is selected from one or more of the following: trimethylolpropane triacrylate, trimethylolpropane trimethylacrylate, pentaerythritol triacrylate, triallyl isocyanurate, ethoxylated trimethylolpropane triacrylate, propoxylated trimethylolpropane triacrylate, ethoxylated glyceryl triacrylate, propoxylated glyceryl triacrylate, pentaerythritol tetraacrylate, ethoxylated pentaerythritol tetraacrylate, trimethylolpropane tetraacrylate, bis-trimethylolpropane tetraacrylate, bis-trimethylolpropane tetramethacrylate, propoxylated pentaerythritol tetraacrylate, tricyclodecane dimethanol diacrylate, propoxylated neopentyl glycol diacrylate, ethoxylated bisphenol A diacrylate, ethoxylated bisphenol A dimethacrylate, 2-butyl-2-ethyl-1,3-propylene glycol diacrylate, diethylene glycol dimethacrylate, triethylene glycol dimethacrylate, and polyethylene glycol dimethacrylate; and/or
the coupling agent is selected from one or more of the following: γ-chloropropyl methoxysilane, dimethylvinyl ethoxysilane, vinyl tris(β-methoxyethoxy)silane, γ-methacryloxypropyl trimethoxysilane, vinyl triacetoxysilane, γ-glycidyl ether oxypropyl trimethoxysilane, 3-(trimethoxysilyl)propyl-2-methyl-2-acrylate, anilino methyl triethoxysilane, octyl trimethoxysilane; and/or
the antioxidant is selected from one or more of the following: β-[3,5-di-tert-butyl -4-hydroxyphenyl] propionic acid n-octadecyl alcohol ester, tetra[β-(3,5-di-tert-butyl-4-hydroxyphenyl) propionic acid]pentaerythritol ester, 1,2-bis[(3-(3,5- di-tert-butyl-4-hydroxyphenyl)propionyl]hydrazine, 2,2'-oxamido-bis[ethyl-3-(3,5-di-tert-butyl-4-hydroxyphenyl)]propionate, N,N'-hexamethylene bis(3,5-di-tert-butyl-4-hydroxyphenyl propanamide), 1,3,5-tris(3,5-di-tert-butyl-4-hydroxylbenzyl)-1,3,5-triazine-2,4,6(1H,3H,5H) triketone, triethylene glycol bis[3-(3-tert-buty-5-methyl-4-hydroxyphenyl)propionate], 4,6-bis(octylthiomethyl)o-cresol, tri[2,4-di-tert-butylphenyl] phosphite, bis[2,4-di-tert-butyl phenyl]pentaerythritol diphosphite, and bis(2,6-di-tert- butyl-4-methylphenyl)pentaerythritol diphosphate.
